# EUROPÄISCHE PATENTANMELDUNG

(11) **EP 4 575 049 A1**
(43) Veröffentlichungstag der Anmeldung: **25.06.2025**
(21) Anmeldenummer: 23218055.4
(22) Anmeldetag: 19.12.2023
(51) Int. Cl.: C30B 25/02, C23C 16/458, C30B 25/12, C30B 29/06

(54) **VORRICHTUNG UND VERFAHREN ZUR HERSTELLUNG EINER HALBLEITERSCHEIBE UNTER VERMINDERTEM AUTODOPING**

(71) Anmelder: Siltronic AG, 81677 München (DE)
(72) Erfinder: Edmaier, Walter, 84384 Wittibreut (DE); Hager, Christian, 84556 Kastl (DE); Stettner, Thomas, 83329 Waging (DE)
(74) Vertreter: Hasenhütl, Eva

(57) **Zusammenfassung**

Die Erfindung betrifft eine Schichtabscheideanordnung (1) für einen epi-Reaktor zur Herstellung einer Halbleiterscheibe mit wenigstens einer epitaktischen Schicht, wobei die Schichtabscheideanordnung (1) eine Lochsuszeptoreinheit (1.1) und einen Preheatring (1.2) umfasst, wobei die Lochsuszeptoreinheit (1.1) eine Lochsuszeptoreinheitoberseite (1.12) und eine Lochsuszeptoreinheitunterseite (1.13) aufweist, wobei, wenigstens während eines epi-Abscheide-Modus, (i) der Preheatring (1.2) die Lochsuszeptoreinheit (1.1) über eine Spalteinheit (1.3), insbesondere in Form eines Luftspaltringes, beabstandet wenigstens abschnittsweise umgibt, wobei die Lochsuszeptoreinheit (1.1) dazu ausgebildet ist, sich mit einer vorgebbaren Drehgeschwindigkeit um eine Höhenachse der Lochsuszeptoreinheit (1.1) gegenüber dem Preheatring (1.2) zu drehen, und (ii) die Schichtabscheideanordnung (1) weiterhin wenigstens eine Dichtringeinheit (1.4) umfasst, die an der Schichtabscheideanordnung (1) derart angeordnet und dazu ausgebildet ist, an der Spalteinheit (1.3) eine physische Barriereeinheit zwischen der Lochsuszeptoreinheitoberseite (1.12) und der Lochsuszeptoreinheitunterseite (1.13) bereitzustellen.

## Beschreibung

### Technisches Gebiet

Die Erfindung betrifft eine Schichtabscheideanordnung für einen epi-Reaktor zur Herstellung einer Halbleiterscheibe mit wenigstens einer epitaktischen Schicht. Die Erfindung betrifft weiterhin ein Verfahren zur Herstellung einer Halbleiterscheibe umfassend das Abscheiden wenigstens einer epitaktischen Schicht unter Verwendung der Schichtabscheideanordnung. Die Erfindung betrifft schließlich eine Halbleiterscheibe umfassend eine dotierte Substratscheibe und wenigstens eine darauf abgeschiedene epitaktische Schicht.

### Stand der Technik und technische Aufgabe

Im Zusammenhang mit epi-Beschichtungsprozessen von (hoch-)dotierten Substratscheiben in epi-Reaktoren ist die Problematik bekannt, dass während des Abscheidens einer epitaktischen Schicht auf einer (hoch-)dotierten Substratscheibe (z.B. bordotierte Substratscheibe) zur Herstellung einer Halbleiterscheibe, aufgrund der hohen vorherrschenden Epi-Prozess-Temperaturen Dotierstoffe aus der Substratscheibe, welche in einer Lochsuzeptoreinheit in der Schichtabscheideanordnung abgelegt sind, zunächst von der Rückseite der Substratscheibe (d.h. die einer Lochsuszeptoreinheit innerhalb des epi-Reaktors zugewandten Seite der Substratscheibe) während des epi-Abscheide-Modus über die Gasphase in das Abscheidegas (unkontrolliert) gelangen und dann schließlich überwiegend im Randbereich der Vorderseite der Substratscheibe (d.h. der Seite der Substratscheibe, auf welcher eine epitaktische Schicht während des epi-Abscheide-Modus abgeschieden wird) in die epitaktische Schicht eingebaut werden. Dieses unerwünschte Phänomen ist unter dem Begriff "autodoping" bekannt, welches zu einer radialen Schwankung des spezifischen Widerstands entlang der abgeschiedenen epitaktischen Schicht der Halbleiterscheibe führt, welche üblicherweise mit der Kenngröße "Radiale-Widerstands-Variation" (RRV) angegeben wird. Hierbei wird der RRV Wert [%] aus gemessenen, individuellen R-Werten resultierend aus einer vorgebbaren Anzahl von auf einem Messraster (kreuzförmigen Messraster) an der epitaktischen Schicht der Halbleiterscheibe liegenden Messpunkte gemäß der Gleichung RRV [%] = (Rₘₐₓ - Rₘᵢₙ) / (Rₘₐₓ + Rₘᵢₙ) ermittelt (insbesondere nach Semi Standards M62-0317 (Specification for Silicon Epitaxial Wafers), 2017).

Zur Verbesserung des RRV Werts ist aus dem Stand der Technik bekannt, die (hoch-)dotierte Substratscheibe zunächst mit einer LTO (Low Thermal Oxide) Schicht auf der Rückseite der Halbleiterscheibe (d.h. die einer Lochsuszeptoreinheit innerhalb des epi-Reaktors zugewandten Seite der Substratscheibe) versiegelt vorzusehen. Danach wird die Substratscheibe inklusive aufgebrachter LTO Schicht in einem epi-Reaktor innerhalb einer Lochsuszeptoreinheit angeordnet und dem epi- Abscheidemodus unterworfen. Diese LTO Schicht wirkt als Dotierstoffdiffusionssperrschicht und hat den Zweck ein Ausdiffundieren der Dotierstoffe aus der Substratscheibe in die (wenigstens eine) epitaktische Schicht während des Epi-Beschichtungsprozesses möglichst zu verhindern. Durch das Vorsehen einer derartigen Oxidschicht werden zwar nach der epitaktischen Abscheidung vergleichsweise geringere radiale spezifische Widerstände (RRV) erzielt, jedoch kann der Verbleib einer derartigen Oxidschicht an einer hergestellten Halbleiterscheibe als Endprodukt nachteilig sein. Selbst nach einer manuellen und/oder chemischen Nachbearbeitung (z.B. durch eine Reinigung mit HF Anteil) zur Entfernung dieser Schicht verbleiben - insbesondere geschuldet dem Umstand, dass am Rand der Oxidschicht während des Epi-Prozesses ein inhomogenes, epitaktisches Wachstum stattfindet - in unerwünschter Weise Defekte als Rückstand auf der Halbleiterscheibe bestehen, welche unter Verwendung eines Inspektionsgeräts, insbesondere einer EBI-Einheit, mittels Streulichtmessung als Licht-Punkt-Defekte detektierbar sind (bspw. mittels einer EBI-Einheit des Unternehmens Nanophotonics AG mit einer Funktionsweise wie in Abs. 52 der Druckschrift DE102009011622 A1 beschrieben). Diese Defekte treten charakteristischerweise in Form eines im Wesentlichen ringförmig ausgebildeten Defektringes mit hoher Defektdichte bzw. Defektanzahl in der Umgebung des Randbereichs der Halbleiterscheibe auf.

Der vorliegenden Erfindung liegt daher die objektive, technische Aufgabe zu Grunde, in einem epi-Abscheidemodus mittels einer kompakten Lochsuszeptoreinheit einer Schichtabscheideanordnung auf einfache Weise aus einer (hoch-)dotierten Substratscheibe eine Halbleiterscheibe mit einer epitaktischen Schicht herzustellen, welche die oben genannten Nachteile nicht oder zumindest in geringerem Ausmaß aufweist und welche insbesondere einen geringen RRV Wert in Kombination mit einer vergleichsweise defektreduzierten Oberfläche der freien Substratscheibenfläche der finalen Halbleiterscheibe aufweist.

Gelöst wird die Aufgabe gemäß dem ersten Aspekt der vorliegenden Erfindung durch die Bereitstellung einer Schichtabscheideanordnung mit einer Suszeptoreinheit gemäß den Merkmalen in Anspruch 1, wird weiterhin gelöst gemäß einem zweiten Aspekt durch das Verfahren zur Herstellung einer Halbleiterscheibe unter Verwendung der Schichtabscheideanordnung umfassend das Abscheiden wenigstens einer epitaktischen Schicht gemäß den Merkmalen nach Anspruch 7, sowie schließlich gelöst gemäß einem dritten Aspekt durch die Bereitstellung einer Halbleiterscheibe gemäß den Merkmalen nach Anspruch 10. Bevorzugte Ausführungsformen sind Gegenstand der abhängigen Ansprüche.

Der Erfindung liegt hierbei die technische Lehre zugrunde, dass man auf einfache Weise eine Halbleiterscheibe mit vergleichsweise geringer RRV (d.h. geringem RRV Wert) der abgeschiedenen epitaktischen Schicht der Halbleiterscheibe mit vergleichsweise defektreduzierter zweiten Scheibenseite der dotieren Substratscheibe erhält, wenn (i) die Schichtabscheideanordnung zur Herstellung der Halbleiterscheibe mit einer entsprechend ausgestalteten Lochsuszeptoreinheit gegenüber dem Preheatring drehbar (und über eine entsprechend ausgestaltete Spalteinheit voneinander beabstandet) ausgestaltet ist, sodass eine zuverlässige Drehung der Lochsuszeptoreinheit gegenüber dem Preheatring und mithin eine kontinuierliche und gleichmäßige Abscheidung der epitaktischen Schicht während des epi-Abscheide-Modus gewährleistet ist und (ii) zur Bekämpfung des Auftretens des "autodoping" Phänomens in der während des epi-Abscheide-Modus herzustellenden Halbleiterscheibe die Schichtabscheideanordnung mit ihrer Lochsuszeptoreinheit derart ausgestaltet wird, dass während des epi-Abscheidemodus in der Gesamtheit zwischen der Oberseite und der Unterseite der Schichtabscheideanordnung eine zuverlässige physische Barriereeinheit gegen ungewollte Strömungen gewährleistet ist.

### Allgemeine Beschreibung der Erfindung

Gemäß einem ersten Aspekt betrifft die Erfindung daher eine Schichtabscheideanordnung für einen epi-Reaktor zur Herstellung einer Halbleiterscheibe mit wenigstens einer epitaktischen Schicht, wobei die Schichtabscheideanordnung eine Lochsuszeptoreinheit und einen Preheatring umfasst, wobei die Lochsuszeptoreinheit eine Lochsuszeptoreinheitoberseite und eine Lochsuszeptoreinheitunterseite aufweist, und wobei, wenigstens während eines epi-Abscheide-Modus,
▪ der Preheatring die Lochsuszeptoreinheit über eine Spalteinheit, insbesondere in Form eines Luftspaltringes, beabstandet wenigstens abschnittsweise umgibt, wobei die Lochsuszeptoreinheit dazu ausgebildet ist, sich mit einer vorgebbaren Drehgeschwindigkeit um eine Höhenachse, insbesondere eine Höhenmittenachse, der Lochsuszeptoreinheit gegenüber dem Preheatring zu drehen, und wobei
▪ die Schichtabscheideanordnung weiterhin wenigstens eine Dichtringeinheit umfasst, die an der Schichtabscheideanordnung derart angeordnet und dazu ausgebildet ist, an der Spalteinheit eine physische Barriereeinheit zwischen der Lochsuszeptoreinheitoberseite und der Lochsuszeptoreinheitunterseite bereitzustellen.

Der Begriff "zwischen" im Sinne der Erfindung stellt keine Richtungseinschränkung für die Wirkung der physischen Barriere(einheit) dar. Durch die erfindungsgemäße Ausgestaltung einer Schichtabscheideanordnung kann also (insbesondere aufgrund der gewählten relativen Anordnung der Komponenten der Schichtabscheideanordnung bzw. Anordnung der Spalteinheit zueinander) und insbesondere durch die besondere Ausbildung der Komponente der Dichtringeinheit in Bezug auf die Spalteinheit während eines epi-Abscheide-Modus der Schichtabscheideanordnung ein Austausch von wenigstens einem aus Abscheideprozessgasen und Dotierstoffen über die Spalteinheit zwischen der Lochsuszeptoreinheitunterseite und der Lochsuszeptoreinheitoberseite reduziert, insbesondere im Wesentlichen vermieden, werden.

Besonders vorteilhaft ist jedoch, dass eine Strömung von Abscheideprozessgasen über die Spalteinheit aus Richtung der Lochsuszeptoreinheitoberseite in Richtung Lochsuszeptoreinheitunterseite sowie eine Strömung von Dotierstoff über die Spalteinheit aus Richtung der Lochsuszeptoreinheitunterseite in Richtung Lochsuszeptoreinheitoberseite reduziert werden, vorzugsweise im Wesentlichen vermieden werden, kann.

Die Dichtringeinheit kann hierfür grundsätzlich an jeder beliebigen Stelle an der Schichtabscheideanordnung angeordnet werden, solange die beschriebene Funktion zur Schaffung einer Sperrwirkung bzw. einer physischen Barriere(einheit) zwischen der Oberseite und der Unterseite der Schichtabscheideanordnung gewährleistet ist, um den Beitrag zu leisten den "autodoping" Effekt zu reduzieren bzw. im Idealfall zu vermeiden. Bei besonders vorteilhaften Varianten der Schichtabscheideanordnung ist die Dichtringeinheit dabei derart an der Lochsuszeptoreinheit, insbesondere an der Lochsuszeptoreinheitunterseite oder der Lochsuszeptoreinheitoberseite, angeordnet und in Bezug auf den Preheatring angeordnet, dass eine Strömung von Abscheideprozessgasen über die Spalteinheit aus Richtung der Lochsuszeptoreinheitoberseite in die Lochsuszeptoreinheitunterseite reduziert wird, vorzugsweise im Wesentlichen vermieden wird, und dass eine Strömung von Dotierstoff über die Spalteinheit aus Richtung der Lochsuszeptoreinheitunterseite in die Lochsuszeptoreinheitoberseite reduziert wird, vorzugsweise im Wesentlichen vermieden, wird. Alternativ hierzu kann vorgesehen sein, dass die Dichtringeinheit derart an dem Preheatring, insbesondere auf der der Lochsuszeptoreinheitunterseite oder der der Lochsuszeptoreinheitoberseite zugewandten Seite der Schichtabscheideanordnung, angeordnet und in Bezug auf die Lochsuszeptoreinheit angeordnet ist, dass eine Strömung von Abscheideprozessgasen über die Spalteinheit aus Richtung der Lochsuszeptoreinheitoberseite in die Lochsuszeptoreinheitunterseite im Wesentlichen reduziert wird, vorzugsweise im Wesentlichen vermieden wird, und dass eine Strömung von Dotierstoff über die Spalteinheit aus Richtung der Lochsuszeptoreinheitunterseite in die Lochsuszeptoreinheitoberseite reduziert wird, vorzugsweise im Wesentlichen vermieden wird.

Zusätzlich oder alternativ kann die Dichtringeinheit an einer Stelle an der der Lochsuszeptoreinheitunterseite zugewandten Seite der Schichtabscheideanordnung angeordnet sein, insbesondere unmittelbar an der Lochsuszeptoreinheitunterseite angeordnet sein. Bei einer hierzu alternativen Variante kann die Dichtringeinheit an einer Stelle an der der Lochsuszeptoreinheitoberseite zugewandten Seite der Schichtabscheideanordnung, insbesondere an einer Oberseite des Preheatrings, angeordnet sein.

Zusätzlich oder alternativ kann die Dichtringeinheit derart an der Schichtabscheideanordnung angeordnet sein, dass sie die Lochsuszeptoreinheit und den Preheatring, in einer Radialrichtung der Lochsuszeptoreinheit betrachtet, wenigstens teilweise überlappt und die Spalteinheit, insbesondere in Form eines Luftspaltrings, in der Radialrichtung betrachtet im Wesentlichen vollständig überragt.

Mit anderen Worten ist auch denkbar, dass die Dichtringeinheit an der Schichtabscheideanordnung innerhalb der Spalteinheit angeordnet sein kann, solange die oben beschriebene Funktion der Dichtringeinheit als physische Barriereeinheit gewährleistet ist und gleichzeitig trotz der innenliegenden Anordnung innerhalb der Spalteinheit die zuverlässige Drehung der Lochsuszeptoreinheit gegenüber dem Preheatring während des epi-Abscheide-Modus gewährleistet ist.

Obwohl bereits eine einzige entsprechend an der Schichtabscheideanordnung angeordnete Dichtringeinheit die Funktion der Schaffung einer physischen Barriereeinheit zuverlässig übernimmt, kann bei weiteren bevorzugten Varianten vorgesehen sein, dass wenigstens eine weitere Dichtringeinheit angeordnet ist. Bei einer derartigen Schichtabscheideanordnung kann dann beispielweise eine erste Dichtringeinheit an der Suzeptoreinheitunterseite nach einem der hierin beschriebenen Varianten angeordnet sein und eine zweite Dichtringeinheit an der Oberseite des Preheatrings nach einer der hierin beschriebenen Varianten angeordnet sein. Hierdurch werden besonders vorteilhafte Minderungen bis hin zur Vermeidung des Auftretens des "autodoping" Effekts während des epi-Abscheide-Modus erzielt.

Grundsätzlich kann die geometrische Ausgestaltung der Lochsuszeptoreinheit und des Preheatringes und die Lage des Spaltringes und der Dichtringeinheit in beliebiger Weise erfolgen, solange die oben beschriebenen Anforderungen an die Schichtabscheideanordnung hinsichtlich Herstellung der Halbleiterscheibe ohne auftretendem "autodoping" Effekt und hinsichtlich zuverlässiger Drehung der Lochsuszeptoreinheit gegenüber Preheatring und gleichmäßige Abscheidung der epitaktischen Schicht während epi-Abscheidemodus gewährleistet ist. Bei besonders vorteilhaften Varianten der Erfindung ist jedoch vorzugsweise vorgesehen, dass die Preheatringheinheit, vorzugsweise ausgehend von einer Umlaufkante der Lochsuszeptoreinheit, in Bezug auf eine Radialrichtung der Lochsuszeptoreinheit, über eine im Wesentlichen ringförmig um die Lochsuszeptoreinheit ausgebildete Spalteinheit, insbesondere in Form eines Luftspaltringes, beabstandet angeordnet ist und der Preheatring die Lochsuszeptoreinheit dabei wenigstens entlang einer Umfangsrichtung der Lochsuszeptoreinheit wenigstens abschnittsweise, vorzugsweise vollständig, umgibt. Hierdurch werden besonders kompakte, zuverlässige Ausführungen der Schichtabscheideanordnung erreicht.

Die Dichtringeinheit kann grundsätzlich geometrisch beliebig gestaltet sein, solange sie damit die oben im Detail beschriebenen Funktionen an der Schichtabscheideanordnung erzielt. Bei besonders vorteilhaften Varianten ist vorzugsweise die Dichtringeinheit im Wesentlichen ringscheibenförmig ausgebildet; hierbei kann die Dichtringeinheit im Radialschnitt mit im Wesentlichen planparallelen Flächen ausgebildet sein oder im Radialschnitt eine hiervon abweichende Form wie beispielsweise eine L-Form oder Z-Form aufweisen.

Bei weiteren vorteilhaften Varianten kann die Dichtringeinheit im Wesentlichen ringförmig ausgebildet sein und entlang ihrer Radialrichtung betrachtet eine Dichtringbreite in einem Bereich von 5 mm bis 50 mm, vorzugsweise in einem Bereich von 15 mm bis 25 mm, aufweisen. Zusätzlich kann die Spalteinheit in Form eines Luftspaltrings ausgebildet sein und, in Radialrichtung der Lochsuszeptoreinheit betrachtet, eine Spaltbreite im Bereich von 1,2 mm bis 2,6 mm, vorzugsweise im Bereich von 1,5 mm bis 2,2 mm, weiter vorzugsweise im Wesentlichen von 1,9 mm, aufweisen, wobei insbesondere die Spaltbreite entlang der Umfangsrichtung im Wesentlichen konstant ist.

Bei all diesen Varianten der Dichtringausführung werden die oben beschriebenen Funktionen der Dichtringeinheit an der Schichtabscheideanordnung in vollem Umfang erzielt.

Unter Radialrichtung kann grundsätzlich jegliche Richtung ausgehend von einem Mittelpunkt (bzw. Mittenachse) der, insbesondere im Wesentlichen symmetrischen, Lochsuszeptoreinheit in Richtung Spalteinheit und entlang eines Lochsuszeptoreinheit-radius verstanden werden.

Grundsätzlich kann die Dichtringeinheit auf beliebe Art und Weise an der Schichtabscheideanordnung befestigt sein oder physischer Teil davon sein. Bei einer vorteilhaften Variante ist vorzugsweise die Dichtringeinheit an der Schichtabscheideanordnung, beispielsweise an der Lochsuszeptoreinheit oder an dem Preheatring, lösbar befestigt angeordnet. Derartige Gestaltungen erlauben einen sehr flexiblen Austausch der Komponente und Zugang zu weiter innenliegenden Komponenten (insbesondere der Spalteinheit) bei Reparaturen, Wartungen oder anderen Eingriffssituationen in die Schichtabscheideanordnung. Vorzugsweise ist hierbei die Dichtringeinheit über eine Klemmverbindung, Steckverbindung oder über eine Schraubverbindungen an der Lochsuszeptoreinheit oder an dem Preheatring lösbar befestigt.

Vorzugsweise ist die Dichtringeinheit aus einem Material hergestellt, welches SiC oder Graphit oder Quarz umfasst.

Alternativ zu diesen Varianten kann die Dichtringeinheit im Wesentlichen als monolithische Einheit mit der Lochsuszeptoreinheit oder mit dem Preheatring ausgebildet sein. Eine derartige Ausführung reduziert in vorteilhafter Weise die Anzahl an Fugenstellen in der Schichtabscheideanordnung im Vergleich zu lösbaren Verbindungsstellen der Dichtringeinheit.

Die Erfindung hat weiterhin erkannt, dass zur weiteren Reduzierung (bzw. insbesondere im Wesentlichen Vermeidung) des "autodoping" Phänomens in der während des epi-Abscheide-Modus herzustellenden Halbleiterscheibe die Schichtabscheideanordnung mit ihrer Lochsuszeptoreinheit vorzugsweise derart ausgestaltet sein soll, dass eine zuverlässige physische Barriereeinheit zwischen der Oberseite und der Unterseite der Schichtabscheideanordnung und auch zwischen der Auflagefläche für die Halbleiterscheibe auf der Lochsuszeptoreinheit und der Oberseite der Lochsuszeptoreinheit gewährleistet ist.

Die Aufnahmestelle an der Lochsuszeptoreinheit für die Substratscheibe kann grundsätzlich beliebig gestaltet sein. Besonders vorteilhafte Ausführungen zur Reduzierung bzw. Vermeidung des "autodoping" Effekts in der herzustellenden Halbleiterscheibe werden erreicht, wenn auch eine zuverlässige physische Barriereeinheit zwischen der Auflagefläche für die Halbleiterscheibe auf der Lochsuszeptoreinheit und der Oberseite der Lochsuszeptoreinheit gewährleistet ist. Dies kann in vorteilhafter Weise dadurch gelingen, indem die Auflagefläche vorzugsweise derart gestaltet und geneigt ist (d.h. durch Gestaltung der geometrischen Form), dass die darauf abgelegte Substratscheibe hierbei selbst zur physischen Barriereeinheit wird bzw. als solche wirkt. Um diesen vorteilhaften Effekt zu erzielen, ist hierzu bei besonders vorteilhaften Varianten vorgesehen, dass die Lochsuszeptoreinheit an der Lochsuszeptoreinheitoberseite eine Ausnehmung in Form einer Substratscheibenaufnahmeeinheit aufweist, welche wiederum eine Substratscheibenaufnahmefläche umfasst, die im Wesentlichen nach Art einer Mantelinnenfläche eines Kegelstumpfes bzw. trichterförmig ausgebildet ist, wobei diese Fläche ausgehend von einem Ledge-Bezugspunkt auf einem Bezugskreis an der Substratscheibenaufnahmefläche eine Neigung gegenüber einer Radialrichtung der Lochsuszeptoreinheit und einer Horizontalebene der Lochsuszeptoreinheit in Form eines Ledgewinkels aufweist, wobei der Ledgewinkel eine Winkelgröße im Bereich von 0,0° bis 2,0°, vorzugsweise im Bereich 0,1° bis 1,0°, weiter vorzugsweise im Bereich 0,2° bis 0,5°, aufweist und entlang einer Umfangsrichtung der Lochsuszeptoreinheit betrachtet im Wesentlichen konstant ist mit einer maximalen Streuung von 1 %, vorzugsweise maximal 0,5 %, weiter vorzugsweise von maximal 0,25 %, entlang der Umfangsrichtung.

Mit anderen Worten kann durch die gezielte Wahl der geometrischen Gestaltung der Auflagefläche, nämlich in Form dieser kegelstumpfartigen bzw. trichterformartigen Substratscheibenaufnahmefläche innerhalb der Lochsuszeptoreinheit, eine Auflagefläche für eine Substratscheibe geschaffen werden, die bei einer abgelegten Substratscheibe während des epi-Abscheide-Modus dann einen weitestgehend fugenfreien, also "dichten" (insbesondere im Wesentlichen ringförmigen) Kontaktbereich (zwischen Substratscheibe und Auflagefläche an Lochsuszeptoreinheit) entstehen lässt, der eine weitere physische Barrie gegen ungewollte Strömungen zwischen Oberseite und Unterseite der Schichtabscheideanordnung bildet und somit einen positiven Beitrag zur Reduzierung bzw. im Wesentlichen Vermeidung des "autodoping" Effekts in der epitaktischen Schicht leistet.

Bei besonders vorteilhaften Varianten ist zur Erzielung der Reduzierung, insbesondere Vermeidung, des "autodoping" Effekts vorgesehen, dass die Substratscheibenaufnahmefläche selbst keine Locheinheiten umfasst. Innerhalb der Innenbodenfläche der Substratscheibenaufnahmeeinheit der Lochsuszeptoreinheit sind hingegen vorzugsweise Locheinheiten verteilt vorgesehen, wie es auch bei der gattungsgemäßen Lochsuszeptoreinheit vorgesehen ist (worauf hier nicht näher eingegangen wird).

Besonders vorteilhaft ist es auch, wenn die Substratscheibenaufnahmefläche vorzugsweise eine Ebenheit-Formtoleranz im Bereich 0,002 mm bis 0,012 mm, vorzugsweise im Bereich 0,005 mm bis 0,008 mm, aufweist. Auch eine derartige Ebenheit der Substratscheibenaufnahmefläche leistet bei einer aufgelegten Substratscheibe einen Beitrag für eine weitestgehend fugenfreie, also "dichte" Auflage und gewährleistet somit die geforderte physische Barriere.

Die Lage des Bezugskreises legt insbesondere den Startbereich der Neigung (Ledgewinkel α_{L}) der Substratscheibenaufnahmefläche innerhalb der Substratscheibenaufnahmeeinheit fest. Vorzugsweise fällt der Bezugskreis mit der inneren Umlaufkante der Phase der Substratscheibenaufnahmeeinheit zusammen. Bei alternativen, vorteilhaften Varianten kann der Bezugskreis von dieser inneren Umlaufkante in Richtung Höhenmittenachse der Lochsuszeptoreinheit beabstandet verlaufen; kann also einen geringeren Bezugsradius aufweisen als der (gedachte) Radius zur inneren Umlaufkante der Substratscheibenaufnahmeeinheit.

Einen weiteren vorteilhaften Beitrag zur Reduzierung bzw. im Wesentlichen Vermeidung des "autodoping" Phänomens in der epitaktischen Schicht während des epi-Abscheide-Modus kann erzielt werden, wenn vorzugsweise vorgesehen ist, dass an der der Lochsuszeptoreinheitunterseite zugewandten Seite der Schichtabscheideanordnung eine Spüleinheit mit einem Spülgas, insbesondere mit Wasserstoff, vorgesehen ist. Hierbei kann die geometrische Ausrichtung einer Spüldüse der Spüleinheit und der Spüldruck des Spülgases an der Spüleinheit vorgebbar einstellbar sein.

Durch die Bereitstellung der oben beschriebenen physischen Barrieeinheiten kann in vorteilhafter Weise reduziert werden, insbesondere im Wesentlichen vermieden werden, dass Prozessgase von der Oberseite in die Unterseite der Schichtabscheideanordnung gelangen und Beschichtungen bzw. Ablagerungen verursachen, wodurch in vorteilhafter Weise eine Spülgasspülung, die insbesondere eine Wasserstoffspülung ist, mittels der Spüleinheit unter der Lochsuszeptoreinheit bis auf 3 slm reduziert werden kann (im Vergleich zu üblicherweise höherliegenden Werten im Bereich von 8 slm bis zu 30 slm).

Gemäß einem weiteren, zweiten Aspekt betrifft die Erfindung ein Verfahren zur Herstellung einer Halbleiterscheibe unter Verwendung der eben beschriebenen Schichtabscheideanordnung nach einem der oben beschriebenen Varianten (bzw. Kombinationen daraus), umfassend das Abscheiden wenigstens einer epitaktischen Schicht auf einer (hoch-)dotierten Substratscheibe, welche keine Dotierdiffusionssperrschicht, insbesondere keine LTO Schicht, aufweist, zur Herstellung der Halbleiterscheibe in einem epi-Reaktor, wobei das Verfahren folgende Schritte umfasst:
▪ Positionieren einer zweiten Scheibenseite der dotieren Substratscheibe an einer Lochsuszeptoreinheit, insbesondere an einer Substratscheibenaufnahmefläche, einer Schichtabscheideanordnung nach einem der oben beschriebenen Ausgestaltungen bzw. Varianten für die Schichtabscheideanordnung (bzw. jegliche Kombination der oben beschriebenen bevorzugten Varianten),
▪ Starten eines epi-Abscheide-Modus der Schichtabscheideanordnung
▪ Abscheiden wenigstens einer epitaktischen Schicht auf einer ersten Scheibenseite der dotierten Substratscheibe während des epi-Abscheide-Modus.

Hierbei ist vorgesehen, dass wenigstens während des epi-Abscheide-Modus eine Drehung der Lochsuszeptoreinheit um eine Höhenmittenachse der Lochsuszeptoreinheit gegenüber dem Preheatring mit einer vorgebbaren Drehgeschwindigkeit, insbesondere im Bereich von 25 rpm bis 60 rpm, stattfindet.

Unter epi-Abscheide-Modus ist vorzugsweise der Prozessmodus zu verstehen, der innerhalb eines (üblich gestalteten) epi-Reaktors den kompletten Abscheideprozess der wenigstens einen epitaktischen Schicht auf die Substratscheibe umfasst.

Vorzugsweise umfasst der epi-Abscheide-Modus neben dem eigentlichen Abscheideprozess auch diesem vorgelagerte und nachgelagerte Prozesszeiten, während welcher sich beispielsweise lediglich die Lochsuszeptoreinheit mit der aufgelegten Substratscheibe gegenüber dem Preheatring dreht, ohne dass es gleichzeitig zu einer Abscheidung kommt. Die Schichtabscheideanordnung ist vorzugsweise dazu ausgebildet, dass an ihr zeitlich versetzt unterschiedliche epi-Abscheide-Modi ausgeführt werden können, wobei sich die Modi beispielsweise in der Durchflussrate der Abscheidegase im epi-Reaktor, der Art des Abscheidemediums, in dem vorgegebenen Epi-Prozess-Temperaturfenster, in der Drehgeschwindigkeit der Lochsuszeptoreinheit, etc. unterscheiden können.

Vorzugsweise ist die Substratscheibe als eine einkristalline Siliziumscheibe ausgebildet und die abgeschiedene wenigstens eine epitaktische Schicht eine einkristalline Siliziumschicht.

Mittels des erfindungsgemäßen Verfahrens unter Verwendung der oben beschriebenen Schichtabscheideanordnung (d.h. bei im Wesentlichen Vermeidung eines "autodoping" Effekts während des epi-Abscheide-Modus) kann eine Halbleiterscheibe mit den eingangs beschriebenen vorteilhaften Eigenschaften hinsichtlich RRV Wert der epitaktischen Schicht und mit vergleichsweise defektreduzierter Oberflächenqualität der finalen Halbleiterscheibe (insbesondere hinsichtlich der Oberflächenseite der Substratscheibe, welche im Stand der Technik zumindest temporär mit einer LTO Schicht versehen ist) vollumfänglich erzielt werden.

Einen weiteren vorteilhaften Beitrag zur Reduzierung bzw. im Wesentlichen Vermeidung des "autodoping" Phänomens in der epitaktischen Schicht während des epi-Abscheide-Modus kann erzielt werden, wenn das Verfahren weiterhin vorzugsweise vorsieht, dass während des epi-Abscheide-Modus an der einer Lochsuszeptoreinheitunterseite zugewandten Seite der Schichtabscheideanordnung eine Spüleinheit mit einem Spülgas, insbesondere in Form von Wasserstoff, vorgesehen ist, wobei die Spülung mittels des Spülgases, insbesondere in Form einer Wasserstoffspülung, unter der Lochsuszeptoreinheit vorgebbar kontrolliert und variierbar, insbesondere auf mindestens 3 slm und maximal 30 slm vorgebbar kontrolliert und variierbar, über den epi-Abscheide-Modus gehalten werden kann.

Bei weiteren bevorzugten Varianten des Verfahrens ist vorzugsweise vorgesehen, dass nach Abschluss der Abscheidung wenigstens einer epitaktischen Schicht und nach Beendigung des epi-Abscheide-Modus die hergestellte Halbleiterscheibe einen Endreinigungsschritt erfährt, der eine chemische Reinigung der Halbleiterscheibe umfasst.

Gemäß einem weiteren, dritten Aspekt betrifft die Erfindung schließlich eine Halbleiterscheibe umfassend eine Substratscheibe und wenigstens eine epitaktische Schicht, wobei
▪ die Substratscheibe eine Dotierung mittels wenigstens einem Dotierstoff, insbesondere Bor, aufweist,
▪ die wenigstens eine epitaktische Schicht an einer ersten Scheibenseite der Substratscheibe angeordnet ist, und
▪ die Halbleiterscheibe:
   eine Radiale-Widerstands-Variation (RRV) in einem Bereich von 1,30 % bis 2,20 % aufweist, und an einer zweiten Scheibenseite der Substratscheibe wenigstens 1 Defekt und weniger als 200 Defekte aufweist, welche unter Verwendung eines Inspektionsgeräts mittels Streulichtmessung als Licht-Punkt-Defekte detektierbar sind, und welche an einem, wenigstens abschnittsweise, im Wesentlichen ringförmig ausgebildeten Defektring angeordnet sind, welcher sich innerhalb eines im Wesentlichen ringförmigen Bereichs an der zweiten Scheibenseite erstreckt, wobei der Bereich eine radiale Breite von 3 mm aufweist und sein äußerer Umfang im Wesentlichen mit dem Halbleiterscheibenrand zusammenfällt.

Die erfindungsgemäße Halbleiterscheibe mit ihrem vorteilhaften RRV Wert und gleichzeitig ihrer vergleichsweise defektreduzierten zweiten Scheibenseite ist ein unmittelbares Resultat einer epitaktischen Abscheidung auf einer bordotierten Substratscheibe gemäß dem erfindungsgemäßen Verfahrens durchgeführt an der erfindungsgemäßen Schichtabscheideanordnung (d.h. u.a. bei vollkommener Abstinenz einer LTO Schicht). Diese wenigen (wenigstens 1 Defekt und weniger als 200) Defekte an der erfindungsgemäßen Halbleiterscheibe resultieren hierbei insbesondere lediglich aus Kratzern oder aus reibungsbehafteten Ablagebedingungen des Halbleiterscheibenrands an der Substratscheibenauflagefläche während des epi-Modus (und eben nicht zusätzlich durch eine hohe Anzahl an zusätzlichen Defekten infolge LTO-Schichtrückständen in diesem Bereich wie im Stand der Technik der Fall ist). Vorzugsweise liegt die Anzahl dieser Defekte in einem Bereich von 1 Defekt bis 100 Defekte, weiter vorzugsweise in einem Bereich von 6 bis 100 Defekte.

Diese Defekte (in ihrer vorteilhaft vergleichsweise geringen Anzahl) werden insbesondere unter Verwendung eines Inspektionsgeräts mittels Streulichtmessung als Licht-Punkt-Defekte detektierbar, insbesondere unter Verwendung einer EBI-Einheit (bspw. des Unternehmens Nanophotonics AG mit einer Funktionsweise wie in Par. [0053] in DE102009011622 A1 beschrieben).

Mit anderen Worten ist vorzugsweise vorgesehen, dass keine Schicht in Form einer Dotierdiffussionssperrschicht, insbesondere in Form einer Low Thermal Oxide (LTO) Schicht, an der zweiten Scheibenseite der Substratscheibe angeordnet ist, wobei insbesondere zu keinem Zeitpunkt der Herstellung der Halbleiterscheibe eine Low Thermal Oxide (LTO) Schicht an der zweiten Scheibenseite der Substratscheibe angeordnet ist. Mit anderen Worten ist insbesondere vorgesehen, dass keine Rückstände in Form von Defekten einer Low Thermal Oxide (LTO) Schicht an der zweiten Scheibenseite der Substratscheibe angeordnet sind.

Bei bevorzugten Varianten kann vorgesehen sein, dass die dotierte Substratscheibe mit Dotierstoff Bor einen Substratwiderstand der Substratscheibe zwischen 0,005 und 0,020 Ohmcm ausbildet, und/oder die Halbleiterscheibe eine RRV in einem Bereich von 1,40 % bis 2,10 %, vorzugsweise in einem Bereich von 1,45 % bis 2,00 %, aufweist.

Vorzugsweise ist die Substratscheibe als eine einkristalline Siliziumscheibe ausgebildet und die abgeschiedene wenigstens eine epitaktische Schicht eine einkristalline Siliziumschicht.

Vorzugsweise weist die abgeschiedene epitaktische Schicht eine durchschnittliche Schichtdicke in einem Bereich von 1,5 µm bis 20 µm auf. Die Erfindung ist allerdings nicht auf diesen Bereich beschränkt und eine größere oder kleinere Schichtdicke der abgeschiedenen epitaktischen Schicht ist möglich.

Vorzugsweise weist die Substratscheibe eine durchschnittliche Schichtdicke von im Wesentlichen 775 µm auf. Die Erfindung ist allerdings nicht auf diesen Bereich beschränkt und eine größere oder kleinere Schichtdicke der Substratscheibe ist möglich.

Die Erfindung ist besonders geeignet für hergestellte Halbleiterscheiben mit einem Zieldurchmesser in einem Bereich von 290 bis 310 mm, insbesondere für eine Halbleiterscheibe mit einem Zieldurchmesser von im Wesentlichen 300 mm ("300 mm Wafer"), ist jedoch nicht darauf beschränkt. Es ist beispielsweise u.a. auch die Herstellung eines "200 mm" Wafers denkbar (mit einer entsprechenden Anpassung des Durchmessers der Ausnehmungseinheit der Suszeptoreinheit).

Bei weiteren bevorzugten Varianten der Halbleiterscheibe kann die Halbleiterscheibe derart ausgebildet sein, dass sie für eine dotierte Substratscheibe der Halbleiterscheibe mit einem Substratwiderstand in einem Bereich von 0,005 bis 0,008 Ohmcm eine RRV der Halbleiterscheibe in einem Bereich von 1,40 % bis 2,10 %, vorzugsweise in einem Bereich von 1,45 % bis 2,00 %, ausbildet. Alternativ hierzu kann die Halbleiterscheibe derart ausgebildet sein, dass sie für eine dotierte Substratscheibe der Halbleiterscheibe mit einem Substratwiderstand in einem Bereich größer 0,008 bis 0,016 Ohmcm eine RRV der Halbleiterscheibe in einem Bereich von 1,40 % bis 1,80 %, vorzugsweise in einem Bereich von 1,45 % bis 1,60 %, weiter vorzugsweise im Wesentlichen von 1,50 %, ausbildet. Insbesondere lassen sich die beschriebenen RRV Werte bei einem epi-Abscheidemodus eines epi-Prozesses erzielen, der bei einer Temperatur im Bereich von 1080°C bis 1125°C, vorzugsweise im Bereich von 1100°C bis 1120°C, durchgeführt wird und insbesondere ist die Substratscheibe bordotiert.

In Relation zu Halbleiterscheiben, welche mittels konventioneller Lochsuszeptoreinheiten (d.h. insbesondere ohne Dichtring und/oder ohne entsprechend geometrisch ausgestaltete Substratscheibenaufnahmefläche innerhalb der Lochsuszeptoreinheit) gefertigt werden, zeigen die beschriebenen bevorzugten Varianten der Halbleiterscheiben weiterhin den Vorteil, dass ihre RRV Werte im Vergleich zu RRV Werten jener Halbleiterscheiben, welche mittels dieser konventionellen Lochsuszeptoreinheiten und welche unter Einsatz von Substratscheiben (ebenfalls) ohne Dotierdiffusionssperrschicht hergestellt wurden, deutlich niedriger sind. Darüber hinaus unterliegt der RRV Wert der Halbleiterscheibe einer geringeren Sensitivität in Bezug auf eine Abhängigkeit von der Dotierstoffmenge in der Substratscheibe (mit anderen Worten eine geringere Abhängigkeit vom Substratwiderstand). Letztgenannter Effekt ermöglicht einen flexiblen Einsatz der Schichtabscheideanordnung in dem epi-Reaktor für unterschiedliche epi-Prozessführungen, da zügigere Einstellungen bzw. Umrüstungen an dem epi-Reaktor für Substratscheiben unterschiedlicher Dotierstoffmenge realisierbar sind im Vergleich zu bekannten Ausführungen der Schichtabscheideanordnung (mit konventionellem Lochsuszeptor).

Beispielsweise kann hierbei bei vorteilhaften Varianten der Halbleiterscheibe der Substratwiderstand der Substratscheibe der Halbleiterscheibe in einem Bereich von 0,005 bis 0,008 Ohmcm liegen und die RRV der Halbleiterscheibe einen Prozentwert im Bereich von 40 % bis 50% einer Referenz-RRV entsprechen, welche bei gleichem Substratwiderstand und gleich ausgebildeter Substratscheibe als Referenzsubstratscheibe einer Referenzhalbleiterscheibe ausgebildet wird, deren wenigstens eine epitaktische Schicht mittels einer (konventionellen) Lochsuszeptoreinheit, d.h. insbesondere ohne Dichtringeinheit und/oder ohne entsprechend geometrisch ausgestaltete Substratscheibenaufnahmefläche innerhalb der Lochsuszeptoreinheit ausgestaltetet, auf der Referenzsubstratscheibe bei gleichen epi-Abscheidemodus Einstellungen abgeschieden wird. Alternativ kann der Substratwiderstand der Substratscheibe der Halbleiterscheibe in einem Bereich größer 0,008 bis 0,012 Ohmcm liegen und die RRV der Halbleiterscheibe einen Prozentwert im Bereich von 40 % bis 65 % einer Referenz-RRV entsprechen, welche bei gleichem Substratwiderstand und gleich ausgebildeter Substratscheibe als Referenzsubstratscheibe einer Referenzhalbleiterscheibe ausgebildet wird, deren wenigstens eine epitaktische Schicht mittels einer (konventionellen) Lochsuszeptoreinheit, d.h. insbesondere ohne Dichtringeinheit und/oder ohne entsprechend geometrisch ausgestaltete Substratscheibenaufnahmefläche innerhalb der Lochsuszeptoreinheit ausgestaltetet, auf der Referenzsubstratscheibe bei gleichen epi-Abscheidemodus Einstellungen abgeschieden wird. Alternativ kann der Substratwiderstand der Substratscheibe der Halbleiterscheibe in einem Bereich größer 0,012 bis 0,016 Ohmcm liegen und die RRV der Halbleiterscheibe einen Prozentwert im Bereich von 60 % bis 85 % einer Referenz-RRV entsprechen, welche bei gleichem Substratwiderstand und gleich ausgebildeter Substratscheibe als Rreferenzsubstratscheibe einer Referenzhalbleiterscheibe ausgebildet wird, deren wenigstens eine epitaktische Schicht mittels einer (konventionellen) Lochsuszeptoreinheit, d.h. insbesondere ohne Dichtringeinheit und/oder ohne entsprechend geometrisch ausgestaltete Substratscheibenaufnahmefläche innerhalb der Lochsuszeptoreinheit ausgestaltetet, auf der Substratscheibe bei gleichem epi-Abscheidemodus Einstellungen abgeschieden wird. Insbesondere lassen sich die beschriebenen RRV Werte bei einem epi-Abscheidemodus eines epi-Prozesses erzielen, der bei einer Temperatur im Bereich von 1080°C bis 1125°C, vorzugsweise im Bereich von 1100°C bis 1120°C, durchgeführt wird.

Insbesondere ist die Substratscheibe bordotiert.

### Kurzbeschreibung der Figur

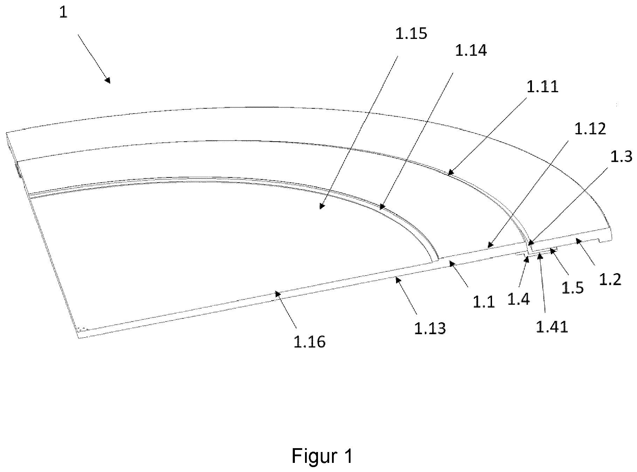

**Figur 1** zeigt einen schematischen Ausschnitt einer dreidimensionalen Ansicht einer Schichtabscheideanordnung 1 mit einer Lochsuszeptoreinheit 1.1, Preheatring 1.2, Spalteinheit 1.3 und Dichtringeinheit 1.4 (Spüleinheit nicht gezeigt).

### Bevorzugtes Ausführungsbeispiel

Im Folgenden wird ein bevorzugtes Ausführungsbeispiel der erfindungsgemäßen Schichtabscheideanordnung 1 beschrieben. Weiterhin wird ein bevorzugtes Ausführungsbeispiel der erfindungsgemäßen Halbleiterscheibe (umfassend eine bordotierte Siliziumsubstratscheibe und eine abgeschiedene epitaktische einkristalline Siliziumschicht ) beschrieben, welche mittels dieser Schichtabscheideanordnung 1 gemäß dem erfindungsgemäßen Verfahren hergestellt wird.

Figur 1 zeigt einen schematischen Ausschnitt einer dreidimensionalen Ansicht der Schichtabscheideanordnung 1 mit einer Lochsuszeptoreinheit 1.1 und einem Preheatring 1.2. Hierbei ist der Preheatring 1.2 ausgehend von einer Umlaufkante 1.11 der Lochsuszeptoreinheit 1.1 in Bezug auf eine Radialrichtung der Lochsuszeptoreinheit 1.1 über eine im Wesentlichen ringförmig um die Lochsuszeptoreinheit 1.1 ausgebildete Spaltringeinheit 1.3 in Form eines Luftspaltringes 1.3 beabstandet angeordnet und der Preheatring umgibt dabei die Lochsuszeptoreinheit 1.1 entlang der Umfangsrichtung der Lochsuszeptoreinheit 1.1. Der Luftspaltring 1.3 weist dabei in Radialrichtung der Lochsuszeptoreinheit 1.1 betrachtet eine Spaltbreite von 1,9 mm auf, wobei die Spaltbreite entlang der Umfangsrichtung im Wesentlichen konstant bleibt. Diese Ausführung gewährleistet eine zuverlässige Drehung (mit einer vorgebbaren Drehgeschwindigkeit z.B. im Bereich von 25 rpm bis 60 rpm, hier im Wesentlichen in der Höhe von 50 rpm) der Lochsuszeptoreinheit 1.1 gegenüber dem Preheatring 1.2 um die Höhenmittenachse und dadurch eine gleichmäßige Abscheidung der epitaktischen Schicht auf der an der Lochsuszeptoreinheit 1.1 abgelegten Substratscheibe (konkret auf einer ersten Scheibenseite der Substratscheibe) während eines epi-Abscheide-Modus.

Die Dichtringeinheit 1.4 der Schichtabscheideanordnung 1, wie in Figur 1 gezeigt, ist dazu ausgebildet, an dem Luftspaltring 1.3 eine physische Barriereeinheit zwischen einer Lochsuszeptoreinheitoberseite 1.12 und der Lochsuszeptoreinheitunterseite 1.13 bereitzustellen.

Die Dichtringeinheit 1.4 ist im vorliegenden Ausführungsbeispiel im Wesentlichen ringscheibenförmig ausgebildet, besteht aus SiC und ist unmittelbar an der Lochsuszeptoreinheitunterseite 1.13 angeordnet. Die ringscheibenförmige Gestalt der Dichtringeinheit weist in dem Radialschnitt in Figur 1 eine im Wesentlichen Z-förmige Form auf, wobei hier die Dichtringeinheit 1.4 über mehrere lösbare Klemmverbindungen an der Lochsuszeptoreinheitunterseite 1.13 entlang der Umfangsrichtung 1.11 verlaufend an der Lochsuszeptoreinheit befestigt ist (nicht näher gezeigt). Weiterhin ist die Dichtringeinheit 1.4 derart an der Schichtabscheideanordnung 1 angebracht, dass sie die Lochsuszeptoreinheit 1.1 und den Preheatring 1.2, in einer Radialrichtung der Lochsuszeptoreinheit 1.1 betrachtet, teilweise überlappt und den Luftspaltring in der Radialrichtung betrachtet vollständig überragt. Im vorliegenden Ausführungsbeispiel verbleibt ein Spiel 1.5 zwischen Unterseite des Preheatrings 1.2 und der zugewandten Seite des Dichtringschenkels 1.41, wobei für die Größe des Spiels 1.5 die Maßgabe gilt, dass das Spiel 1.5 so groß wie nötig sein soll, um einen sicheren, zuverlässigen Vorgang des epi-Abscheide-Modus zu gewährleisten, jedoch so klein wie möglich sein soll, um die nötige physische Barriere weiterhin zu gewährleisten. Im vorliegenden Fall beträgt das Spiel 1.5 in Vertikalrichtung 1,0 mm. Dafür weist die Dichtringeinheit im vorliegenden Ausführungsbeispiel auch eine entsprechende Länge entlang der Radialrichtung auf, im vorliegenden Fall von 20 mm (sodass ein ungewollter Strömungsweg zwischen Lochsuszeptoreinheitoberseite 1.12 und der Lochsuszeptoreinheitunterseite 1.13 verlängert bzw. erschwert wird).

Es versteht sich, dass bei anderen Ausführungen auch andere Abmessungen, geometrische Gestaltungen und Anordnungsstellen (z.B. an der Preheatringoberseite) für die Dichtringeinheit sowie ein Spiel 1.5 anderer Größe gewählt werden können, solange die Dichtringeinheit 1.4 die Funktion einer physische Barriereeinheit zwischen der Lochsuszeptoreinheitoberseite 1.12 und der Lochsuszeptoreinheitunterseite 1.13 sicherstellt (mit anderen Worten, um den Austausch von Abscheideprozessgasen und Bordotierstoffen über die Spalteinheit 1.3 im Wesentlichen zu verhindern).

Die Schichtabscheideanordnung 1 umfasst eine Ausnehmung in Form einer Substratscheibenaufnahmeeinheit 1.15 zur Aufnahme der abgelegten Substratscheibe, welche wiederum eine Substratscheibenaufnahmefläche 1.14 und auch eine Innenbodenfläche 1.16 (welche mit Locheinheiten versehen ist wie bei konventionellen Lochsuszeptoren) umfasst. Konkret ist eine zweite Scheibenseite der abgelegten Substratscheibe der Substratscheibenaufnahmefläche 1.14 zugewandt.

Die Substratscheibenaufnahmefläche 1.14 ist im Wesentlichen nach Art einer Mantelinnenfläche eines Kegelstumpfes bzw. im Wesentlichen trichterförmig ausgebildet, wobei die Substratscheibenaufnahmefläche 1.14 ausgehend von einem (gedachten) Ledge-Bezugspunkt L-BP auf einem (gedachten) Bezugskreis BK an der Substratscheibenaufnahmefläche 1.14 eine Neigung gegenüber einer Radialrichtung der Lochsuszeptoreinheit und einer Horizontalebene der Lochsuszeptoreinheit in Form eines Ledgewinkels α_{L} aufweist und der Ledgewinkel α_{L} im vorliegenden Ausführungsbeispiel eine Winkelgröße von 0,2° aufweist und entlang der Umfangsrichtung der Lochsuszeptoreinheit 1.1 betrachtet im Wesentlichen konstant verläuft mit einer maximalen Streuung 0,25 % entlang der Umfangsrichtung. Diese geometrische Gestaltung der Substratscheibenaufnahmefläche 1.14 gewährleistet für die Substratscheibe eine weitestgehend fugenfreie, also "dichte" Auflage und stellt somit eine physische Barriere zwischen der Auflagefläche für die Halbleiterscheibe auf der Lochsuszeptoreinheit 1.1 und der Lochsuszeptoreinheitoberseite 1.12 her, die den "autodoping" Effekt weiter reduziert, insbesondere vermeidet.

Die Lage des Bezugskreises BK legt den Startbereich der Neigung (Ledgewinkel α_{L}) der Substratscheibenaufnahmefläche 1.14 innerhalb der Substratscheibenaufnahmeeinheit 1.15 fest. Im vorliegenden Ausführungsbeispiel fällt der Bezugskreis mit der inneren Umlaufkante der Phase der Substratscheibenaufnahmeeinheit 1.15 zusammen. Es versteht sich, dass bei anderen vorteilhaften Varianten der Bezugskreis BK von dieser inneren Umlaufkante in Richtung Höhenmittelachse beabstandet verlaufen kann, also einen geringeren Bezugsradius aufweist.

Unter Radialrichtung kann hierbei jegliche Richtung ausgehend von der Höhenmittelachse der im Wesentlichen symmetrischen Lochsuszeptoreinheit 1.1 und rechtwinkelig auf die Höhenmittenachse in Richtung Luftspaltring 1.3 und entlang eines Lochsuszeptoreinheit-radius verstanden werden.

Weiterhin weist die Substratscheibenaufnahmefläche eine Ebenheit-Formtoleranz von 0,010 mm auf. Auch diese geometrische Gestaltung der Substratscheibenaufnahmefläche 1.14 gewährleistet für die Substratscheibe eine weitestgehend fugenfreie, also "dichte" Auflage und stellt somit eine physische Barriere zwischen der Auflagefläche für die Halbleiterscheibe auf der Lochsuszeptoreinheit 1.1 und der Lochsuszeptoreinheitoberseite 1.12 her, die den "autodoping" Effekt weiter reduziert, insbesondere im Wesentlichen vermeidet.

Zur Erzielung der Reduzierung des "autodoping" Effekts ist weiterhin vorgesehen, dass die Substratscheibenaufnahmefläche 1.14 selbst hierbei keine Locheinheiten umfasst. Innerhalb der Innenbodenfläche 1.16 der Substratscheibenaufnahmeeinheit 1.15 der Lochsuszeptoreinheit 1.1 sind hingegen, wie es auch bei der gattungsgemäßen Lochsuszeptoreinheit vorgesehen ist, Locheinheiten verteilt vorgesehen (worauf hier nicht näher eingegangen wird; in Figur 1 wird in Lochsuszeptormitte eine geringe Anzahl von Locheinheiten beispielhaft angedeutet).

Zur weiteren vorteilhaften Reduzierung bzw. im Wesentlichen Vermeidung des "autodoping" Phänomens in der abzuscheidenden epitaktischen Schicht während des epi-Abscheide-Modus ist im vorliegenden Ausführungsbeispielweiterhin vorgesehen, dass eine an der der Lochsuszeptoreinheitunterseite 1.13 zugewandten Seite der Schichtabscheideanordnung 1 vorgesehene Spüleinheit 1.6 mit einem Spülgas in Form von Wasserstoff vorgesehen ist, der Spülgasspülung dank des Vorsehens der Dichtringeinheit 1.4 an der Schichtabscheideanordnung Lochsuszeptoreinheit und dank der Ausgestaltung und zusätzlichen Funktion der Auflagefläche (Barriereeinheit) unter derLochsuszeptoreinheit 1.1 bis auf 3 slm reduzierbar ist.

Insbesondere durch das Zusammenspiel all dieser strukturellen (Anordnung der Dichtringeinheit 1.4; geometrische Gestaltung der Substratscheibenaufnahmefläche 1.14; geometrische Gestaltung der Spalteinheit 1.3) und prozesstechnischen Vorkehrungen (reduzierte Spülung durch Spüleinheit 1.6 der Lochsuszeptoreinheitunterseite 1.13) an der Schichtabscheideanordnung 1 werden besonders vorteilhafte Reduzierungen hinsichtlich des "autodoping" Effekts bis hin zur kompletten Vermeidung des "autodoping" Effekts an der herzustellenden Halbleiterscheibe erreicht.

Die Abscheidung der epitaktischen Schicht auf der ersten Scheibenseite der bordotierten Substratscheibe während des epi-Abscheide-Modus erfolgt in einem Temperaturbereich von 1100°C bis 1120°C. Nach dem vollständigen Abscheiden der epitaktischen Schicht auf der ersten Scheibenseite der bordotierten Substratscheibe während des epi-Abscheide-Modus und nach kompletter Beendigung des epi-Abscheide-Modus wird die hergestellte Halbleiterscheibe aus dem epi-Reaktor entnommen.

Die mittels der Schichtabscheideanordnung 1 hergestellte Halbleiterscheibe, deren bordortierte Substratscheibe einen (mittels Schichtwiderstandsmessung gemäß SEMI Standards MF673 *"TEST METHODS FOR MEASURING RESISTIVITY OF SEMICONDUCTOR WAFERS OR SHEET RESISTANCE OF SEMICONDUCTOR FILMS VVITH A NONCONTACT EDDY-CURRENT GAUGE"* ermittelten) Substratwiderstand von 0,005 Ohmcm aufweist, weist eine RRV der epitaktischen Schicht in Höhe von im Wesentlichen 2,10 % auf. Dieser RRV Wert wurde mit der Ermittlungsmethode nach SEMI Standards M62-0317 (Specification for Silicon Epitaxial Wafers), 2017) (RRV [%] = (Rₘₐₓ - Rₘᵢₙ) / (Rₘₐₓ + Rₘᵢₙ)) unter Berücksichtigung von neun ermittelten R-Werten resultierend aus neun Messpunkten an der epitaktischen Schicht ermittelt (wobei die neun Messpunkte auf einem kreuzförmigen Messraster an der epitaktischen Schicht angeordnet wurden, wobei das Messraster durch den Halbleiterscheibennotch führt; die vier dem Randbereich der Halbleiterscheibe zugeordneten Messpunkte sind dabei unter Berücksichtigung eines Randausschlusses angeordnet, wobei der Messpunkt in der Umgebung des Notches hierbei unter Berücksichtigung eines Randausschlusses von 10 mm gewählt (d.h. in einer Radialrichtung 10 mm vom Rand beanstandet auf dem Messraster angeordnet) und die restlichen drei Messpunkte, die im Randbereich der Halbleiterscheibe liegen, unter Berücksichtigung eines Randausschlusses von 5 mm gewählt werden (d.h. in einer Radialrichtung 5 mm vom Rand beanstandet auf dem Messraster angeordnet).

Die RRV der epitaktischen Schicht der Halbleiterscheibe in Höhe von 2,10 % entspricht grundsätzlich dem RRV Wert, den die Halbleiterscheibe nach der epitaktischen Abscheidung bei Vorsehen einer LTO Schicht als Dotierdiffusionssperrschicht an der zweiten Schichtseite der Substratscheibe bei konventioneller Herstellung an einem konventionellen Lochsuszeptoreinheit erlangen würde, jedoch nun mit dem Vorteil, dass nach dem epi-Abscheidemodus manuell und/oder chemisch (z.B. mit HF Anteil) überhaupt keine LTO Schicht entfernt werden muss und somit in vorteilhafter Weise auch die Oberflächeneigenschaften an der zweiten Scheibenseite der Substratscheibe im Vergleich zum Stand der Technik mit LTO Schicht dahingehend verbessert sind, als die zweite Scheibenseite der dotieren Substratscheibe vergleichsweise defektreduziert ist. Konkret weist die zweite Scheibenseite der Substratscheibe im vorliegenden Ausführungsbeispiel 6 Defekte auf, die an einem, wenigstens abschnittsweise, im Wesentlichen ringförmig ausgebildeten Defektring angeordnet sind, welcher sich innerhalb eines im Wesentlichen ringförmigen Bereichs an der zweiten Scheibenseite erstreckt, wobei der Bereich eine radiale Breite von 3 mm aufweist und sein äußerer Umfang im Wesentlichen mit dem Halbleiterscheibenrand zusammenfällt

Diese 6 Defekte (in ihrer vorteilhaft geringen Anzahl) an der Halbleiterscheibe sind Defekte, welche unter Verwendung eines Inspektionsgeräts mittels Streulichtmessung als Licht-Punkt-Defekte detektiert wurden (Defekte resultierend aus Rückständen einer entfernten LTO Schicht (Stand der Technik) würden grundsätzlich ebenfalls als Licht-Punkt-Defekte in diesem Halbleiterscheibenbereich und zudem in hoher Anzahl (gemeinsam mit den anderen Defekten als Licht-Punkt-Defekte in Summe über 200) detektiert werden; mangels LTO-Schichtrückständen bei der erfindungsgemäßen Halbleiterscheibe repräsentieren die detektierten 6 Licht-Punkt-Defekte ausschließlich Defekte resultierend aus Kratzern oder aus Reibungsstellen an der Substratscheibenaufnahmefläche oder ähnlichen Szenarien und dies in dieser vergleichsweise geringen Defektanzahl).

In Relation zu Halbleiterscheiben, welche mittels konventioneller Lochsuszeptoreinheiten (d.h. insbesondere ohne Dichtring und/oder ohne entsprechend geometrisch ausgestaltete Substratscheibenaufnahmefläche innerhalb der Lochsuszeptoreinheit) gefertigt werden, weist die Halbleiterscheibe weiterhin den Vorteil auf, dass ihr RRV Wert (2,10 %) im Vergleich zu dem RRV Wert jener Halbleiterscheibe, welche mittels dieser konventionellen Lochsuszeptoreinheiten bei gleichem Substratwiderstand (0,005 Ohmcm) und welche (ebenfalls) unter Einsatz von Substratscheibe ohne Dotierdiffusionssperrschicht hergestellt wurden, deutlich niedriger ist. Im vorliegenden Ausführungsbeispiel entspricht die RRV der Halbleiterscheibe ca. 40 % einer Referenz-RRV, welche bei gleichem Substratwiderstand und gleich ausgebildeter Substratscheibe einer Referenzhalbleiterscheibe ausgebildet wird, deren epitaktische Schicht mittels eines (konventionellen) Lochsuszeptors ohne Dichtringeinheit 1.4 und ohne dem Vorsehen einer entsprechend geometrisch ausgestalteten Substratscheibenaufnahmefläche 1.14 auf einer der Substratscheibe äquivalenten Substratscheibe abgeschieden wird.

## Patentansprüche

1. Schichtabscheideanordnung (1) für einen epi-Reaktor zur Herstellung einer Halbleiterscheibe mit wenigstens einer epitaktischen Schicht, wobei
▪ die Schichtabscheideanordnung (1) eine Lochsuszeptoreinheit (1.1) und einen Preheatring (1.2) umfasst, wobei die Lochsuszeptoreinheit (1.1) eine Lochsuszeptoreinheitoberseite (1.12) und eine Lochsuszeptoreinheitunterseite (1.13) aufweist,
wobei, wenigstens während eines epi-Abscheide-Modus,
▪ der Preheatring (1.2) die Lochsuszeptoreinheit (1.1) über eine Spalteinheit (1.3), insbesondere in Form eines Luftspaltringes, beabstandet wenigstens abschnittsweise umgibt, wobei die Lochsuszeptoreinheit (1.1) dazu ausgebildet ist, sich mit einer vorgebbaren Drehgeschwindigkeit um eine Höhenachse der Lochsuszeptoreinheit (1.1) gegenüber dem Preheatring (1.2) zu drehen, und
▪ die Schichtabscheideanordnung (1) weiterhin wenigstens eine Dichtringeinheit (1.4) umfasst, die an der Schichtabscheideanordnung (1) derart angeordnet und dazu ausgebildet ist, an der Spalteinheit (1.3) eine physische Barriereeinheit zwischen der Lochsuszeptoreinheitoberseite (1.12) und der Lochsuszeptoreinheitunterseite (1.13) bereitzustellen.

2. Schichtabscheideanordnung nach Anspruch 1, wobei
▪ die Dichtringeinheit (1.3) im Wesentlichen ringscheibenförmig ausgebildet ist,
und/oder
▪ die Dichtringeinheit (1.4) an einer Stelle an der der Lochsuszeptoreinheitunterseite (1.13) zugewandten Seite der Schichtabscheideanordnung (1), insbesondere unmittelbar an der Lochsuszeptoreinheitunterseite (1.13), angeordnet ist oder an einer Stelle an der der Lochsuszeptoreinheitoberseite (1.12) zugewandten Seite der Schichtabscheideanordnung (1), insbesondere an einer Oberseite des Preheatrings (1.2), angeordnet ist,
und/oder
▪ die Dichtringeinheit (1.4) derart an der Schichtabscheideanordnung (1) angeordnet ist, dass sie die Lochsuszeptoreinheit (1.1) und den Preheatring (1.2), in einer Radialrichtung der Lochsuszeptoreinheit (1.1) betrachtet, wenigstens teilweise überlappt und die Spalteinheit (1.4), insbesondere in Form eines Luftspaltrings, in der Radialrichtung betrachtet im Wesentlichen vollständig überragt.

3. Schichtabscheideanordnung nach Anspruch 1 oder 2, wobei
▪ die Dichtringeinheit (1.4) im Wesentlichen ringförmig ausgebildet ist und entlang ihrer Radialrichtung betrachtet eine Dichtringbreite in einem Bereich von 5 mm bis 50 mm, vorzugsweise in einem Bereich von 15 mm bis 25 mm, aufweist, und die Spalteinheit (1.3) in Form eines Luftspaltrings, in Radialrichtung der Lochsuszeptoreinheit (1.1) betrachtet, eine Spaltbreite im Bereich von 1,2 mm bis 2,6 mm, vorzugsweise im Bereich von 1,5 mm bis 2,2 mm, weiter vorzugsweise im Wesentlichen von 1,9 mm, aufweist, wobei insbesondere die Spaltbreite entlang der Umfangsrichtung im Wesentlichen konstant ist.

4. Schichtabscheideanordnung nach einem der vorherigen Ansprüche, wobei
▪ die Dichtringeinheit (1.4) an der Schichtabscheideanordnung (1), insbesondere an der Lochsuszeptoreinheit (1.1) oder an dem Preheatring (1.2), lösbar befestigt angeordnet ist und die Dichtringeinheit (1.4) insbesondere aus Material hergestellt ist, welches SiC oder Graphit oder Quarz umfasst,
oder
▪ die Dichtringeinheit (1.4) im Wesentlichen als monolithische Einheit mit der Lochsuszeptoreinheit (1.1) oder dem Preheatring (1.2) ausgebildet ist.

5. Schichtabscheideanordnung nach einem der vorherigen Ansprüche, wobei die Lochsuszeptoreinheit (1.1) an der Lochsuszeptoreinheitoberseite (1.12) eine Ausnehmung in Form einer Substratscheibenaufnahmeeinheit (1.15) umfasst, welche eine Substratscheibenaufnahmefläche (1.14) umfasst,
wobei
▪ die Substratscheibenaufnahmefläche (1.14) im Wesentlichen nach Art einer Mantelinnenfläche eines Kegelstumpfes ausgebildet ist, wobei sie ausgehend von einem Ledge-Bezugspunkt auf einem Bezugskreis an der Substratscheibenaufnahmefläche (1.14) eine Neigung gegenüber einer Radialrichtung der Lochsuszeptoreinheit (1.1) und einer Horizontalebene der Lochsuszeptoreinheit (1.1) in Form eines Ledgewinkels aufweist, wobei der Ledgewinkel eine Winkelgröße im Bereich von 0,0° bis 2,0°, vorzugsweise im Bereich 0,1° bis 1,0°, weiter vorzugsweise im Bereich 0,2° bis 0,5°, aufweist und entlang einer Umfangsrichtung der Lochsuszeptoreinheit (1.1) betrachtet im Wesentlichen konstant ist mit einer maximalen Streuung von 1 %, vorzugsweise maximal 0,5 %, weiter vorzugsweise von maximal 0,25 %, entlang der Umfangsrichtung,
und/oder
▪ die Substratscheibenaufnahmefläche (1.1) eine Ebenheit-Formtoleranz in einem Bereich von 0,002 mm bis 0,012 mm, vorzugsweise 0,005 mm bis 0,008 mm, aufweist.

6. Schichtabscheideanordnung nach einem der vorherigen Ansprüche, wobei an der der Lochsuszeptoreinheitunterseite (1.13) zugewandten Seite der Schichtabscheideanordnung (1) eine Spüleinheit mit einem Spülgas, insbesondere mit Wasserstoff, vorgesehen ist, wobei eine Spülgasspülung, insbesondere Wasserstoffspülung, unter der Lochsuszeptoreinheit (1.1) bis auf 3 slm reduzierbar ist.

7. Verfahren zur Herstellung einer Halbleiterscheibe, umfassend das Abscheiden wenigstens einer epitaktischen Schicht auf einer dotierten Substratscheibe, welche keine Dotierdiffussionssperrschicht, insbesondere keine LTO Schicht, aufweist, in einem epi-Reaktor zur Herstellung der Halbleiterscheibe, wobei das Verfahren folgende Schritte umfasst:
▪ Positionieren einer zweiten Scheibenseite der dotieren Substratscheibe an einer Lochsuszeptoreinheit (1.1), insbesondere an einer Substratscheibenaufnahmefläche (1.14), einer Schichtabscheideanordnung (1) nach einem der Ansprüche 1 bis 6,
▪ Starten eines epi-Abscheide-Modus der Schichtabscheideanordnung (1),
▪ Abscheiden wenigstens einer epitaktischen Schicht auf einer ersten Scheibenseite der dotierten Substratscheibe während des epi-Abscheide-Modus.

8. Verfahren nach Anspruch 7, wobei
▪ wenigstens während des epi-Abscheide-Modus eine Drehung der Lochsuszeptoreinheit (1.1) um eine Höhenmittenachse der Lochsuszeptoreinheit (1.1) gegenüber dem Preheatring (1.2) mit einer vorgebbaren Drehgeschwindigkeit stattfindet,
und
▪ während des epi-Abscheide-Modus eine an der einer Lochsuszeptoreinheitunterseite (1.13) zugewandten Seite der Schichtabscheideanordnung (1) Spüleinheit mit einem Spülgas, insbesondere in Form von Wasserstoff, vorgesehen ist, wobei die Spülung mittels des Spülgases, insbesondere in Form einer Wasserstoffspülung, unter der Lochsuszeptoreinheit (1.1) auf mindestens 3 slm und maximal 30 slm vorgebbar kontrolliert und variierbar über den epi-Abscheide-Modus gehalten wird.

9. Verfahren nach Anspruch 7 oder 8, wobei nach Abschluss der Abscheidung wenigstens einer epitaktischen Schicht und nach Beendigung des epi-Abscheide-Modus die Halbleiterscheibe einen Endreinigungsschritt erfährt, der eine chemische Reinigung der Halbleiterscheibe umfasst.

10. Halbleiterscheibe umfassend eine Substratscheibe und wenigstens eine epitaktische Schicht, wobei
▪ die Substratscheibe eine Dotierung mit wenigstens einem Dotierstoff aufweist,
▪ die wenigstens eine epitaktische Schicht an einer ersten Scheibenseite der Substratscheibe angeordnet ist,
▪ die Halbleiterscheibe
o eine Radiale-Widerstands-Variation (RRV) in einem Bereich von 1,30 % bis 2,20 % aufweist, und
o an einer zweiten Scheibenseite der Substratscheibe wenigstens 1 Defekt und weniger als 200 Defekte aufweist, welche unter Verwendung eines Inspektionsgeräts mittels Streulichtmessung als Licht-Punkt-Defekte detektierbar sind, und welche an einem, wenigstens abschnittsweise, im Wesentlichen ringförmig ausgebildeten Defektring angeordnet sind, welcher sich innerhalb eines im Wesentlichen ringförmigen Bereichs an der zweiten Scheibenseite erstreckt, wobei der Bereich eine radiale Breite von 3 mm aufweist und sein äußerer Umfang im Wesentlichen mit dem Halbleiterscheibenrand zusammenfällt.

11. Halbleiterscheibe nach Anspruch 10, wobei keine Schicht in Form einer Dotierdiffussionssperrschicht, insbesondere in Form einer Low Thermal Oxide (LTO) Schicht, insbesondere zu keinem Zeitpunkt der Herstellung der Halbleiterscheibe, an der zweiten Scheibenseite der Substratscheibe angeordnet ist.

12. Halbleiterscheibe nach Anspruch nach Anspruch 10 oder 11, wobei keine Rückstände in Form von Defekten einer Low Thermal Oxide (LTO) Schicht an der zweiten Scheibenseite der Substratscheibe angeordnet sind.

13. Halbleiterscheibe nach einem der Ansprüche 10 bis 12, wobei die dotierte Substratscheibe mit Dotierstoff Bor einen Substratwiderstand der Substratscheibe zwischen 0,005 und 0,020 Ohmcm ausbildet, und/oder die Halbleiterscheibe eine RRV in einem Bereich von 1,40 % bis 2,10 %, vorzugsweise von 1,45 % bis 2,00 %, aufweist.

14. Halbleiterscheibe nach einem der Ansprüche 10 bis 13, wobei
▪ die Halbleiterscheibe derart ausgebildet ist, dass sie für eine dotierte Substratscheibe der Halbleiterscheibe mit einem Substratwiderstand in einem Bereich von 0,005 bis 0,008 Ohmcm eine RRV der Halbleiterscheibe in einem Bereich von 1,40 % bis 2,10 %, vorzugsweise in einem Bereich von 1,45 % bis 2,00 %, ausbildet,
oder
▪ die Halbleiterscheibe derart ausgebildet ist, dass sie für eine dotierte Substratscheibe der Halbleiterscheibe mit einem Substratwiderstand in einem Bereich größer 0,008 bis 0,016 Ohmcm eine RRV der Halbleiterscheibe in einem Bereich von 1,40 % bis 1,80 %, vorzugsweise in einem Bereich von 1,45 % bis 1,60 %, weiter vorzugsweise im Wesentlichen von 1,50 %, ausbildet.
